# EUROPEAN PATENT APPLICATION

(11) **EP 2 573 938 A1**
(43) Date of publication of application: **27.03.2013**
(21) Application number: 11306194.9
(22) Date of filing: 22.09.2011
(51) Int. Cl.: H03F 3/217

(54) **A method for signal amplification based on pulse width modulation**

(71) Applicant: Alcatel Lucent, 75007 Paris (FR); Friedrich-Alexander-Universität Erlangen-Nürnberg, 91054 Erlangen (DE)
(72) Inventor: Haslach, Christoph, 70178 Stuttgart (DE); Markert, Daniel, 70435 Stuttgart (DE); Frotzscher, Andreas, 70435 Stuttgart (DE); Yu, Xin, 70435 Stuttgart (DE)
(74) Representative: Kleinbub, Oliver

(57) **Abstract**

The invention concerns a method for signal amplification of an input signal (S) using at least one pulse width modulator (PWM1, PWM2) and at least one switching power amplifier (SPA1, SPA2), wherein the input signal (S) is modulated in said at least one pulse width modulator (PWM1, PWM2) resulting in at least two pulse width modulated signals with two levels (SPWM1, SPWM2), said at least two pulse width modulated signals with two levels (SPWM1, SPWM2) are amplified in said at least one switching power amplifier (SPA1, SPA2) resulting in a multi-level signal with at least three levels (SSPA), and said multi-level signal with at least three levels (SSPA) is converted to an analogue signal resulting in an amplified copy of the input signal, and a transmitter therefor.

## Description

### Field of the invention

The invention relates to a method for signal amplification of an input signal using at least one pulse width modulator and at least one switching power amplifier, and a transmitter adapted to perform said method.

### Background

In order to support highly efficient switching power amplifiers, signals with continuous amplitude, or multi-level signals, need to be converted to 2-level signals. In general, this transformation is executed by so-called delta sigma modulators (DSM), also called sigma delta modulators, or pulse length modulators (PLM), also called pulse width modulators (PWM).

These so-called pulse width modulators (PWM) are promising modulator concepts in the context of switching amplifiers, e.g. for highly efficient switching power amplifiers used for the amplification of radio signals to be transmitted over an air interface in a communication network. In principle, they allow for an ideal conversion of signals with continuous amplitude and limited bandwidth to a time continuous 2-level signal. This 2-level signal is perfectly suited for switching amplifier stages. The 2-level signal can be reconverted to the continuous amplitude signal simply by a reconstruction filter after the amplification stage.

Further applications of pulse width modulators comprise the control of the supply of electrical power for other devices such as in speed control of electric motors, operation of so-called class D audio switching amplifiers or brightness control of light sources.

### Summary

There exist numerous pulse width modulator architectures, but they either suffer from low coding efficiency, spectral deterioration, high sampling frequencies and/or difficulties in implementations. The typical class S setup for radio frequency (RF) applications employing a pulse width modulator looks as follows: an analogue signal is converted to a 2-level signal, e.g. a switching signal, by a pulse width modulator. The resulting signal is amplified by a switching amplifier. The amplified signal is re-converted to a time- and amplitude-continuous signal by a reconstruction filter, which can be a low pass or band pass filter depending on the spectral pureness and the wanted signal band. This filter erases, i.e. attenuates, the out-of-band signal components. If there are many and strong out-of-band signal components, also refered to as quantization noise, this results in strict requirements for the filter characteristics and the termination conditions of this filter. Any non-idealities in these characteristics result in power losses and/or spectral deterioration. Hence, it is important to have a pulse width modulator architecture, that generates a switching signal with a minimum of signal components in the out-of-band region. This means, the coding efficiency of the switching signal, defined as the ratio of the wanted signal power at the carrier frequency and the total signal power, shall be as high as possible.

In principle, an analogue implementation of a pulse width modulator works as described in the following.

A signal with a continuous amplitude is fed to a comparator as a first input signal. The second input signal to the comparator is a sawtooth signal or a triangular signal. In the following only the sawtooth signal is mentioned, but the considerations are valid for triangular signals too. As soon as the ascending amplitude of the sawtooth signal has the same value as the continuous amplitude signal, the output of the comparator switches from voltage-high (VH) to voltage-low (VL). The falling edge of the sawtooth signal resets the output of the comparator to voltage high (VH). The output of the comparator is the PWM signal.

Depending on the implementation, the first input signal of the comparator may also be the sampled version of the continuous amplitude signal, sampled at equidistant time instances.

Simulation results of such a pulse width modulator according to the state of the art for a 5MHz UMTS signal (UMTS = Universal Mobile Telecommunications System) with 5 MHz bandwidth and 5.6dB Peak to Average Power Ratio (PAPR), and with the carrier frequency of the UMTS signal being 2.14GHz, and the frequency of the triangular trigger (reference) signal being 5GHz, show that the wanted signal at 2.14GHz only contains a small fraction of the total signal power. The majority of signal power is allocated at the first harmonic component of the reference signal at 5GHz. As a consequence, the coding efficiency is only 11.98% in this case.

The object of the invention is thus to propose a method for signal amplification based on pulse width modulation that has high coding efficieny, low pulse rates and a simple structure that simplifies implementation and improves energy efficiency.

The basic idea of the invention is to create out of an input signal a distributed multi-level pulse width modulated signal which is composed out of 2-level pulse width modulated signals at carrier frequency, and to amplify said 2-level pulse width modulated signals applying the principle of switching power amplification.

Simulations show that applying said method according to the invention leads to the majority of the signal power being now located at the wanted carrier frequency. The coding efficiency is higher than 60% now using the above-described UMTS signal with 5.6dB PAPR, compared to 11.98% using a pulse width modulator according to the state of the art for the same input signal.

The object is thus achieved by a method for signal amplification of an input signal using at least one pulse width modulator and at least one switching power amplifier, wherein
● the input signal is modulated in said at least one pulse width modulator resulting in at least two pulse width modulated signals with two levels,
● said at least two pulse width modulated signals with two levels are amplified in at least one switching power amplifier resulting in a multi-level signal with at least three levels,
● and said multi-level signal with at least three levels is converted to an analogue signal resulting in an amplified copy of the input signal.

The object is furthermore achieved by a transmitter comprising at least one pulse width modulator, at least one switching power amplifier for signal amplification of an input signal, and a converting device for digital-to-analogue conversion, wherein
● said at least one pulse width modulator is adapted to modulate the input signal in said at least one pulse width modulator resulting in at least two pulse width modulated signals with two levels,
● said at least one switching power amplifier is adapted to amplify said at least two pulse width modulated signals with two levels resulting in a multi-level signal with at least three levels,
● and said converting device for digital-to-analogue conversion is adapted to convert said multi-level signal with at least three levels to an analogue signal resulting in an amplified copy of the input signal.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief description of the figures

In the following the invention will be explained further making reference to the attached drawings.
Fig. 1 schematically shows a pulse width modulator according to the state of the art.
Fig. 2 shows a spectrum plot of a power spectral density of a pulse width modulated signal according to the state of the art.
Fig. 3 schematically shows an analogue rf input signal and two constant comparator thresholds C₁ and -C₁ for pulse width modulation.
Fig. 4 schematically shows two pulse width modulated signals which result as output signals of an analogue rf input signal after pulse width modulation in a first and a second pulse width modulator with a constant first and a constant second comparator threshold respectively.
Fig. 5 schematically shows a 3-level pulse width modulated signal which results after combination of the two pulse width modulated signals depicted in fig. 4. In the following the term ternary is used as a synonym of the term 3-level.
Fig. 6 shows a spectrum plot of a power spectral density of a ternary pulse width modulated signal as depicted in fig. 5.
Fig. 7 schematically shows exemplarily a transmitter for amplification of distributed ternary pulse width modulated signals using two pulse width modulators and separate switching power amplifiers according to an embodiment of the invention.
Fig. 8 schematically shows exemplarily a transmitter for amplification of distributed ternary pulse width modulated signals using two pulse width modulators, an inverter and a differential switching power amplifier according to an embodiment of the invention.
Fig. 9 schematically shows exemplarily a transmitter for amplification of distributed ternary pulse width modulated signals using two pulse width modulators, and a differential switching power amplifier according to an embodiment of the invention.
Fig. 10 schematically shows exemplarily a transmitter for amplification of distributed ternary pulse width modulated signals using two pulse width modulators, and a H-bridge power amplifier according to an embodiment of the invention.
Fig. 11 schematically shows exemplarily a transmitter for amplification of distributed ternary pulse width modulated signals using a pulse width modulator, a splitter, a phase shifter and a differential switching power amplifier according to an embodiment of the invention.
Fig. 12 schematically shows exemplarily a transmitter for amplification of distributed ternary pulse width modulated signals using two pulse width modulators, two electro-optical converters and an optical combiner for optical transmission of pulse width modulated signals to switching power amplifiers according to an embodiment of the invention.
Fig. 13 schematically shows exemplarily a transmitter for amplification of distributed ternary pulse width modulated signals according to fig. 9, with additionally two electro-optical converters and two opto-electrical converters for optical transmission of pulse width modulated signals to the differential switching power amplifier according to an embodiment of the invention.
Fig. 14 schematically shows exemplarily a transmitter for amplification of distributed ternary pulse width modulated signals according to fig. 11, with additionally an electro-optical converter and an opto-electrical converter for optical transmission of pulse width modulated signals to the differential switching power amplifier according to an embodiment of the invention.
Fig. 15 schematically shows exemplarily a transmitter for amplification of distributed ternary pulse width modulated signals according to fig. 13, with additionally an optical multiplexer and an optical demultiplexer for combined optical transmission of pulse width modulated signals to the differential switching power amplifier according to an embodiment of the invention.
Fig. 16 schematically shows a differential switching power amplifier architecture relying on a voltage switched circuit topology according to the state of the art.
Fig. 17 schematically shows a differential switching power amplifier architecture relying on a current switched circuit topology according to the state of the art.

### Description of the embodiments

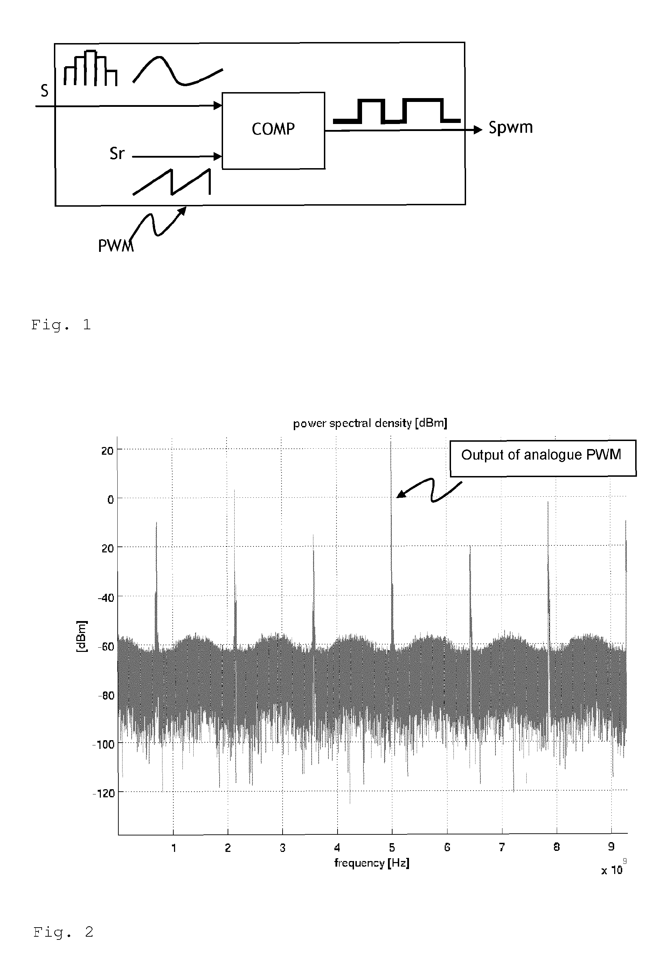

Fig. 1 schematically shows a pulse width modulator PWM according to the state of the art comprising as a basic part a comparator COMP with two inputs and one output.

Depending on the implementation, the input signal S of the pulse width modulator PWM can either be a signal with continuous amplitude, or the sampled version of the continuous amplitude signal, sampled at equidistant time instances.

The input signal S is fed to the first input of the comparator COMP, and a sawtooth signal Sr is fed to the second input of the comparator COMP. As soon as the ascending amplitude of the sawtooth signal Sr has the same value as the input signal S, the output of the comparator switches from voltage-high (VH) to voltage-low (VL) and remains at VL as long as Sr ≥ S holds. The falling edge of the sawtooth signal Sr resets the output of the comparator to voltage high (VH). The pulse width modulated signal Spwm is transmitted from the output of the comparator COMP to the output of the pulse width modulator PWM.

Fig. 2 shows a simulation of a spectrum plot of a power spectral density of a pulse width modulated signal using the pulse width modulator PWM depicted in fig. 1 for a 5MHz UMTS signal with 5 MHz bandwidth and 5.6dB Peak to Average Power Ratio (PAPR). The carrier frequency of the UMTS signal is 2.14GHz, the repetition frequency of a triangular trigger signal, i.e. reference signal, is 5GHz. It can be seen, that the wanted 2.14GHz spectral component only contains a small fraction of the total signal power. The majority of signal power is allocated at the first harmonic component of the reference signal at 5GHz. As a consequence, the coding efficiency is only 11.98% in this case.

According to an embodiment of the invention, a distributed multi-level pulse width modulated signal which is composed out of 2-level pulse width modulated signals at carrier frequency is created out of an input signal, and said 2-level pulse width modulated signals are then amplified applying the principle of switching power amplification.

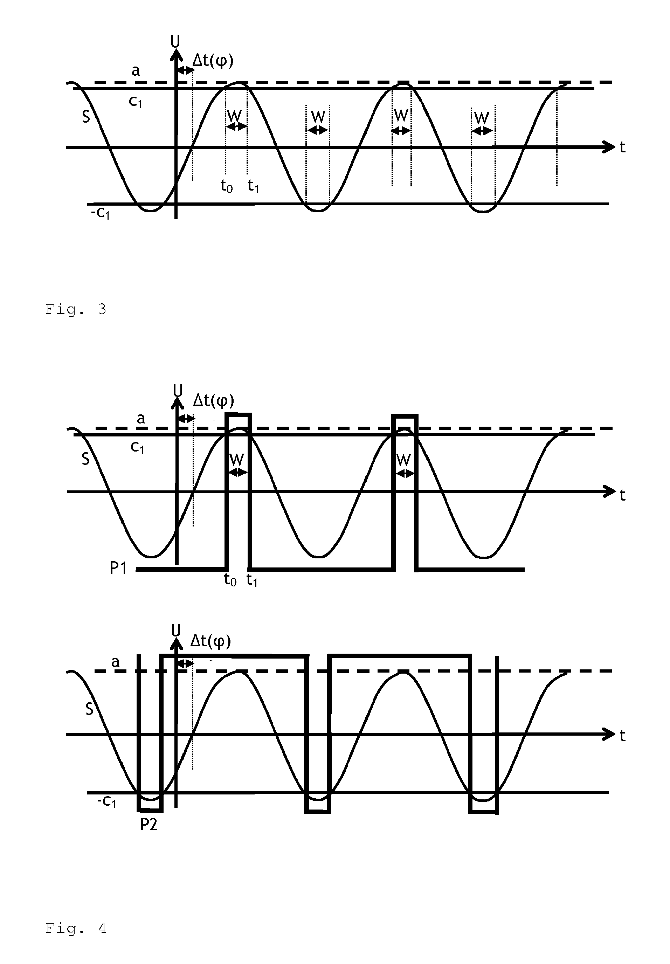

In fig. 3, a signal strength of an input signal S=a*sin (2πf_{c}t+ϕ) is plotted against time t, with a being the envelope of the input signal S, f_{c} being the carrier frequency, and ϕ being the phase of the input signal S. In this example, a is only slowly varying compared to the term sin (2πf_{c}t). The two solid lines refer to two fix comparator thresholds c₁ and -c₁ respectively, which can be implemented e.g. in two 2-level pulse width modulators as will be described later. In the following the term binary is used as synonym of the word 2-level.

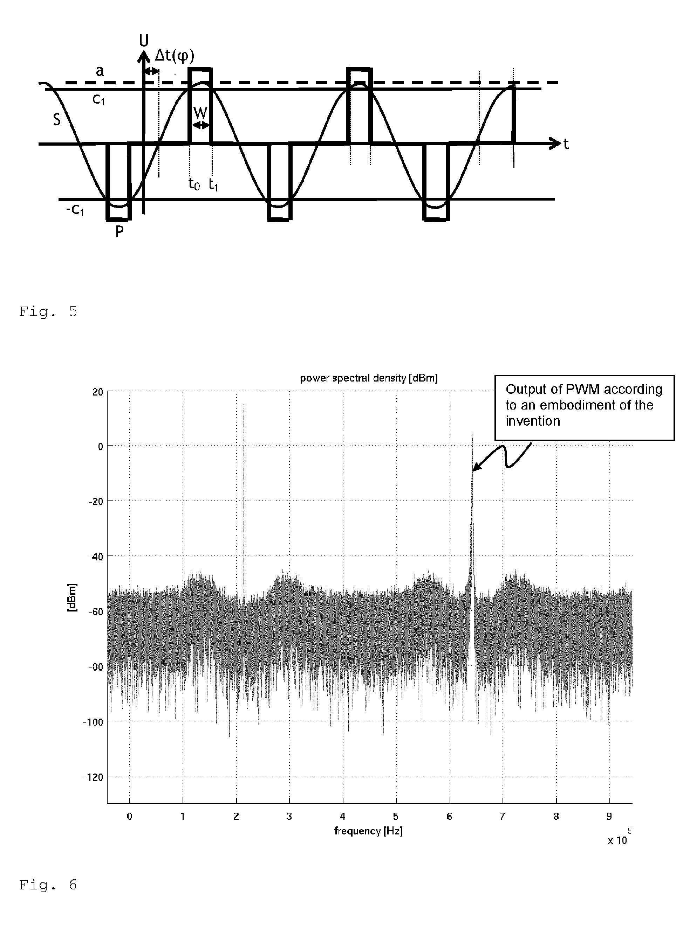

Each time an ascending input signal S crosses the first comparator threshold C₁, a start of a pulse is triggered e.g. at time to as depicted in fig. 3, and each time a descending input signal S crosses the first comparator threshold C₁, an end of a pulse is triggered e.g. at time t₁ as depicted in fig. 3, which leads to pulses with a width W. In an analogue manner, each time a descending input signal S crosses the second comparator threshold -c₁, a start of a negative pulse is triggered, and each time an ascending input signal S crosses the second comparator threshold -c₁, an end of a negative pulse is triggered, which also leads to pulses with a width W. Said pulses with the width W are depicted in fig. 4 and described below. In other words, each positive carrier half wave causes a positive pulse and each negative half wave causes a negative pulse. The resulting signal after combining the signals from fig.4 are depicted in fig. 5 and described below. Between positive pulses and negative pulses and between negative pulses and positive pulses, the resulting signal is set to 0, or generally (VH+VL)/2, which is depicted in fig.5. Thus, applying said pulse width modulation method leads to a ternary pulse width modulated signal with a zero line, and positive and negative pulses.

The ternary pulse width modulated signal can be generated by combining two devices, e.g. two pulse width modulators, each with the functionality of a comparator, where the first device generates the positive pulses, and the second device generates the negative pulses.

In the upper diagram in fig. 4, as in fig. 3, a signal strength of an input signal S=a* sin (2πf_{c}t+ϕ) is plotted against time t, with a being the envelope of the input signal S, f_{c} being the carrier frequency, and ϕ being the phase of the input signal S. Additionally, pulses P1 are depicted resulting from a comparison of the input signal S with the first comparator threshold C₁ as described above under fig. 3.

In the lower diagram in fig. 4, as in fig. 3, a signal strength of an input signal S=a* sin (2πf_{c}t+ϕ) is plotted against time t, with a being the envelope of the input signal S, f_{c} being the carrier frequency, and being the phase of the input signal S. Additionally, pulses P2 are depicted resulting from a comparison of the input signal S with the second comparator threshold -c₁ as described above under fig. 3.

In the diagram in fig. 5, as in fig. 3, a signal strength of an input signal S=a*sin (2πf_{c}t+ϕ) is plotted against time t, with a being the envelope of the input signal S, f_{c} being the carrier frequency, and ϕ being the phase of the input signal S. Additionally, the desired ternary pulse width modulated signal P is depicted which results after adding the pulses P1 resulting from a comparison of the input signal S with the first comparator threshold C₁ to the pulses P2 resulting from a comparison of the input signal S with the second comparator threshold -c₁, as depicted in fig. 4.

As already mentioned above, each positive carrier half wave causes a positive pulse and each negative half wave causes a negative pulse. Between positive pulses and negative pulses and between negative pulses and positive pulses, the ternary pulse width modulated signal P is set to 0. The ternary pulse width modulated signal P can be generated by combining two devices, e.g. two pulse width modulators, each with the functionality of a comparator, where one device generates the positive pulses and the other one generates the negative pulses.

Fig. 6 shows a simulation of a spectrum plot of a power spectral density of a ternary pulse width modulated signal P as depicted in fig. 5 for a 5MHz UMTS signal with 5 MHz bandwidth and 5.6dB Peak to Average Power Ratio (PAPR). The carrier frequency of the UMTS signal is 2.14GHz. The majority of the signal power is now located at the wanted carrier frequency at 2.14GHz. The coding efficiency is higher than 60% in this case, compared to 11.98% in the case a conventional pulse width modulator as depicted in fig. 1 is used for the same input signal. Another crucial advantage is apparent: The requirements for a reconstruction filter can be relaxed significantly, as the quantization noise power is drastically reduced and the spectrum in the vicinity of the carrier frequency is much cleaner. Furthermore, the spectrum from direct current (DC) to the carrier frequency f_{c} is without any distortion peak.

In order to use the invention for linear amplification, either pre-emphasis must be provided which leads to a preemphasized input signal S, or the first and second comparator threshold c₁ and -c₁, as e.g. depicted in fig. 5, must be adapted to the current envelope a of the input signal S.

A key challenge of using multi-level pulse width modulated signals, as e.g. ternary pulse width modulated signals P as described above, is that the multi-level pulse width modulated signals need to be amplified. Thus, several transmitters for amplification of distributed ternary pulse width modulated signals as an example of distributed multi-level pulse width modulated signals are described in the following according to several embodiments of the invention.

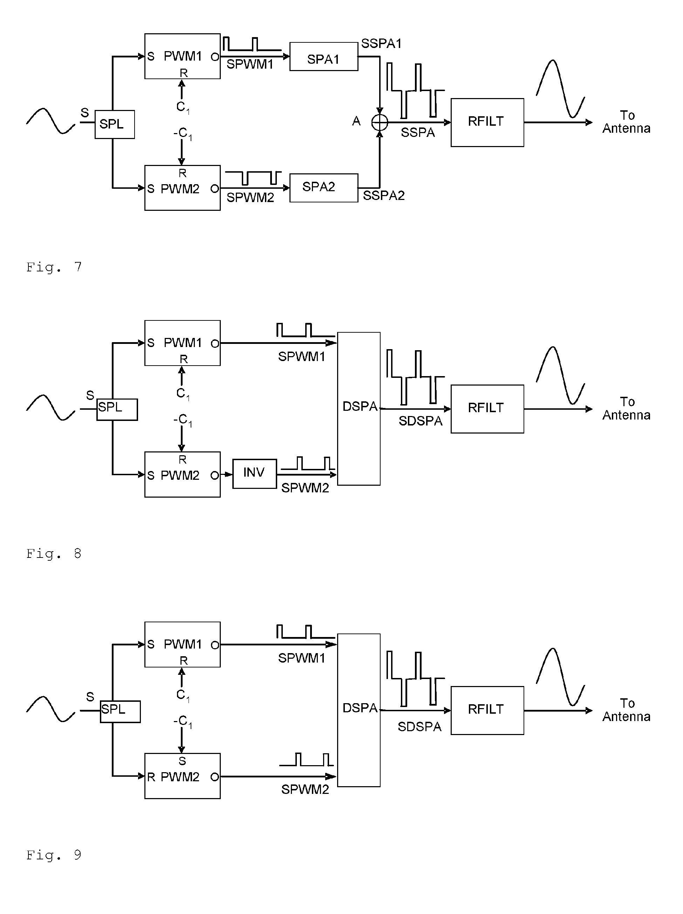

Fig. 7 schematically shows exemplarily a transmitter for amplification of distributed ternary pulse width modulated signals using two pulse width modulators and separate switching power amplifiers according to an embodiment of the invention.

The transmitter comprises a splitter or coupler SPL, a first and a second pulse width modulator PWM1, PWM2, a first and a second switching power amplifier SPA1, SPA2, an adder A, and a reconstruction filter RFILT.

An input signal S=a* sin (2πf_{c}t+ϕ) is duplicated by means of the splitter or coupler SPL. As in the embodiment in fig. 7 only the functionality of a splitter is required, the usage of a splitter SPL is preferred.

The input signal S is transmitted to a signal input of the first pulse width modulator PWM1, and a first comparator threshold C₁ is fed to a reference input of the first pulse width modulator PWM1. As depicted in the upper diagram in fig. 4 and described above, a first pulse width modulated signal SPWM1 results from a comparison of the input signal S with the first comparator threshold C₁, and said first pulse width modulated signal SPWM1 is sent to an input of the first switching power amplifier SPA1.

In the first switching power amplifier SPA1, said first pulse width modulated signal SPWM1, which is a binary pulse width modulated signal, is amplified resulting in an amplified copy SSPAL of the first pulse width modulated signal SPWM1.

The input signal S is also transmitted to a signal input of the second pulse width modulator PWM2, and a second comparator threshold -c₁ is fed to a reference input of the second pulse width modulator PWM2. As depicted in the lower diagram in fig. 4 and described above, a second pulse width modulated signal SPWM2 results from a comparison of the input signal S with the second comparator threshold -c₁, and said second pulse width modulated signal SPWM2 is sent to an input of the second switching power amplifier SPA2.

In the second switching power amplifier SPA2, said second pulse width modulated signal SPWM2, which is a binary pulse width modulated signal, is amplified resulting in an amplified copy SSPA2 of the second pulse width modulated signal SPWM2.

The amplified copy SSPA1 of the first pulse width modulated signal SPWM1, and the amplified copy SSPA2 of the second pulse width modulated signal SPWM2 are added in the adder A resulting in a ternary signal SSPA.

The ternary signal SSPA is then filtered in a reconstruction filter RFILT preferably of low pass or band pass type for extracting the wanted amplified analog inband signal components of the ternary signal SSPA. Said ternary signal SSPA corresponds to an amplified copy of a ternary pulse width modulated signal as e.g. depicted in fig. 5.

Thus, according to the embodiment of the invention the two output signals of the two pulse width modulators SPWM1 and SPWM2 are amplified separately in two switching power amplifiers SPA1 and SPA2, as it is easier to amplify binary pulse width modulated signals than ternary pulse width modulated signals.

Fig. 8 schematically shows exemplarily a transmitter for amplification of distributed ternary pulse width modulated signals using two pulse width modulators, an inverter and a differential switching power amplifier according to an embodiment of the invention.

The transmitter comprises a splitter or coupler SPL, a first and a second pulse width modulator PWM1, PWM2, a signal inverter INV, a differential switching power amplifier DSPA, and a reconstruction filter RFILT.

An input signal S=a* sin (2πf_{c}t+ϕ) is duplicated by means of the splitter or coupler SPL. As in the embodiment in fig. 8 only the functionality of a splitter is required, the usage of a splitter SPL is preferred.

The input signal S is transmitted to a signal input of the first pulse width modulator PWM1, and a first comparator threshold C₁ is fed to a reference input of the first pulse width modulator PWM1. As depicted in the upper diagram in fig. 4 and described above, a first pulse width modulated signal SPWM1 results from a comparison of the input signal S with the first comparator threshold C₁, and said first pulse width modulated signal SPWM1 is sent to a first input of the differential switching power amplifier DSPA.

The input signal S is also transmitted to a signal input of the second pulse width modulator PWM2, and a second comparator threshold -c₁ is fed to a reference input of the second pulse width modulator PWM2. As depicted in the lower diagram in fig. 4 and described above, a second pulse width modulated signal results from a comparison of the input signal S with the second comparator threshold -c₁, and said second pulse width modulated signal is inverted in the signal inverter INV resulting in an inverted second pulse width modulated signal SPWM2. The inverted second pulse width modulated signal SPWM2 is sent to a second input of the differential switching power amplifier DSPA.

In the embodiment depicted in fig. 8, for amplification of the two binary pulse width modulated signals, a differential switching power amplifier DSPA is used. The two inputs of the differential switching amplifier DSPA are fed with the first pulse width modulated signal SPWM1, and with the inverted second pulse width modulated signal SPWM2. Due to the differential operation, the differential switching power amplifier DSPA amplifies separately the two inputs and inherently subtracts them. Thus, for this approach, one of the pulse width modulated output signals needs to be inverted, which is the reason that the binary pulse width modulated signal resulting from the second pulse width modulator PWM2 must be inverted in the signal inverter INV.

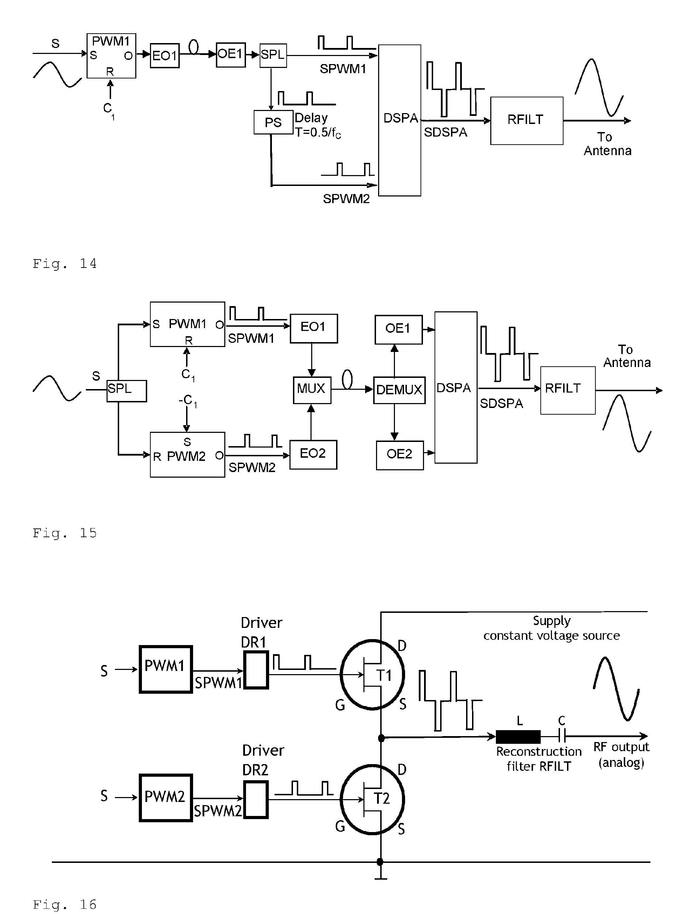

Two examples for an implementation of such a differential switching power amplifier are depicted in figs. 15 and 16, and described below.

The amplification of the first pulse width modulated signal SPWM1, and the inverted second pulse width modulated signal SPWM2 results in a ternary signal SDSPA. Said ternary signal SDSPA corresponds to an amplified copy of a ternary pulse width modulated signal as e.g. depicted in fig. 5.

The ternary signal SDSPA is then filtered in a reconstruction filter RFILT preferably of low pass or band pass type for converting the ternary signal SDSPA into an analogue signal.

Thus, according to the embodiment of the invention, the two output signals of the two pulse width modulators PWM1 and PWM2 are amplified in a differential switching power amplifier DSPA, as this is easier than a direct amplification of ternary pulse width modulated signals.

In an embodiment of the invention using a differential switching power amplifier DSPA for amplification of two binary pulse width modulated signals depicted in fig. 9, instead of introducing an inverter, the input signals of one pulse width modulator PWM1 or PWM2 can be exchanged, i.e. the reference signal input, marked with 'R' in fig. 9, and the desired signal input, marked with 'S' in fig. 9, of one pulse width modulator PWM1 or PWM2 are exchanged with each other, which is equivalent to an inversion of the respective pulse width modulated signal.

Thus, the transmitter depicted in fig. 9 in principle corresponds to the transmitter depicted in fig. 8, with the difference, that no inverter INV is used, but instead the inputs for the input signal S and the second comparator threshold -c₁ of the second pulse width modulator PWM2 are exchanged.

In an alternative of the embodiment, in case the pulse width modulators PWM1 and PWM2 provide differential outputs, the inverted output of one pulse width modulator PWM1 or PWM2 can be used instead of exchanging its input ports.

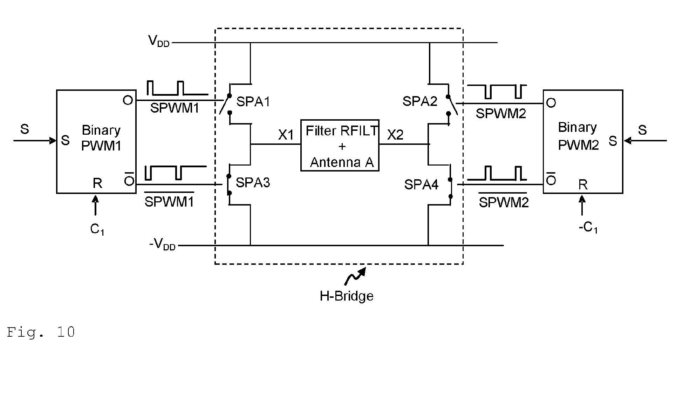

Fig. 10 schematically shows exemplarily a transmitter for amplification of distributed ternary pulse width modulated signals using two pulse width modulators, and a H-bridge power amplifier according to an embodiment of the invention.

The transmitter comprises a first and a second pulse width modulator PWM1, PWM2, and a H-bridge power amplifier. The H-bridge power amplifier in turn comprises four switching power amplifiers SPA1-SPA4, and a processing unit with a reconstruction filter RFILT, and an antenna A.

A first output O of the first pulse width modulator PWM1 is connected to the first switching power amplifier SPA1, and a second output *O̅* of the first pulse width modulator PWM1 is connected to the third switching power amplifier SPA3.

The first and the third switching power amplifier SPA1 and SPA3 are connected to a first input of the processing unit with the reconstruction filter RFILT, and the antenna A.

A first output O of the second pulse width modulator PWM2 is connected to the second switching power amplifier SPA2, and a second output *O̅* of the second pulse width modulator PWM2 is connected to the fourth switching power amplifier SPA4.

The second and the fourth switching power amplifier SPA2 and SPA4 are connected to a second input of the processing unit with the reconstruction filter RFILT, and the antenna A.

An input signal S=a* sin (2πf_{c}t+ϕ) is transmitted to a signal input of the first pulse width modulator PWM1, and a first comparator threshold C₁ is fed to a reference input of the first pulse width modulator PWM1. As depicted in the upper diagram in fig. 4 and described above, a first pulse width modulated signal SPWM1 results from a comparison of the input signal S with the first comparator threshold C₁, and said first pulse width modulated signal SPWM1 is sent via the first output O to the first switching power amplifier SPA1.

Also, an inverted first pulse width modulated signal *̅S̅P̅W̅M̅*̅1̅ is sent via the second output *O̅* of the first pulse width modulator PWM1 to the third switching power amplifier SPA3.

The input signal S is also transmitted to a reference input of the second pulse width modulator PWM2, and a second comparator threshold -c₁ is fed to a signal input of the second pulse width modulator PWM2. As depicted in the lower diagram in fig. 4 and described above, a second pulse width modulated signal SPWM2 results from a comparison of the input signal S with the second comparator threshold -c₁, and said second pulse width modulated signal SPWM2 is sent via the first output O to the second switching power amplifier SPA2.

Also, an inverted second pulse width modulated signal *̅S̅P̅W̅M̅*̅2̅ is sent via the second output *O̅* of the second pulse width modulator PWM2 to the fourth switching power amplifier SPA4.

The H-bridge power amplifier yields a differential ternary signal as depicted in fig. 5 between the points X1 and X2 in Fig. 10, which is an amplified version of the difference between the first and second pulse width modulated signals SPWM1, SPWM2. Let denote the difference between X1 and X2 as SX. This differential ternary signal is delivered to the differential input of the reconstruction filter RFILT and antenna A.

Let denote the HIGH and LOW level of the first binary pulse width modulated signal SPWM1 by VH and VL, respectively. Equivalently, the HIGH and LOW level of the second binary pulse width modulated signal SPWM2 by VH and VL, respectively. If SPWM1 and SPWM2 equals VH, then the differential signal SX between X1 and X2 equals zero. Similarly, if SPWM1 and SPWM2 equals VL, then SX equals zero. If SPWM1 equals VH and SPWM2 equals VL, then SX equals a positive value Vₓ. If SPWM1 equals VL and SPWM2 equals VH, then SX equals -Vₓ. In more detail:
If SPWM1 equals VH and SPWM2 equals VH then
   the symbolic switch of SPA1 connects X1 with VDD,
   the symbolic switch of SPA2 connects X2 with VDD,
   the symbolic switch of SPA3 disconnects X1 from -VDD,
   the symbolic switch of SPA4 disconnects X2 from -VDD.
   Hence X1 equals X2 and SX equals zero.
If SPWM1 equals VL and SPWM2 equals VL then
   the symbolic switch of SPA1 disconnects X1 from VDD,
   the symbolic switch of SPA2 disconnects X2 from VDD,
   the symbolic switch of SPA3 connects X1 with -VDD,
   the symbolic switch of SPA4 connects X2 with -VDD.
   Hence X1 equals X2 and SX=X1-X2 equals zero.
If SPWM1 equals VL and SPWM2 equals VH then
   the symbolic switch of SPA1 disconnects X1 from VDD,
   the symbolic switch of SPA2 connects X2 with VDD,
   the symbolic switch of SPA3 connects X1 with -VDD,
   the symbolic switch of SPA4 disconnects X2 from -VDD.
   Hence X1 is negative, X2 is positive and SX=X1-X2 equals a negative value -Vx.
If SPWM1 equals VH and SPWM2 equals VL then
   the symbolic switch of SPA1 connects X1 with VDD,
   the symbolic switch of SPA2 disconnects X2 from VDD,
   the symbolic switch of SPA3 disconnects X1 from -VDD,
   the symbolic switch of SPA4 connects X2 with -VDD.
   Hence X1 is positive, X2 is negative and SX=X1-X2 equals a positive value Vx.

In conventional state-of-the-art differential switching power amplifiers the output would be undefined, if SPWM1 and SPWM2 equal VL. The H-bridge power amplifier circumvents inherently this problem. The conventional H-Bridge yields well defined outputs for all possible combinations of the logical values of the signals SPWM1 and SPWM2.

The ternary signal is then filtered in a reconstruction filter RFILT preferably of low pass or band pass type for converting the ternary signal into an analogue signal.

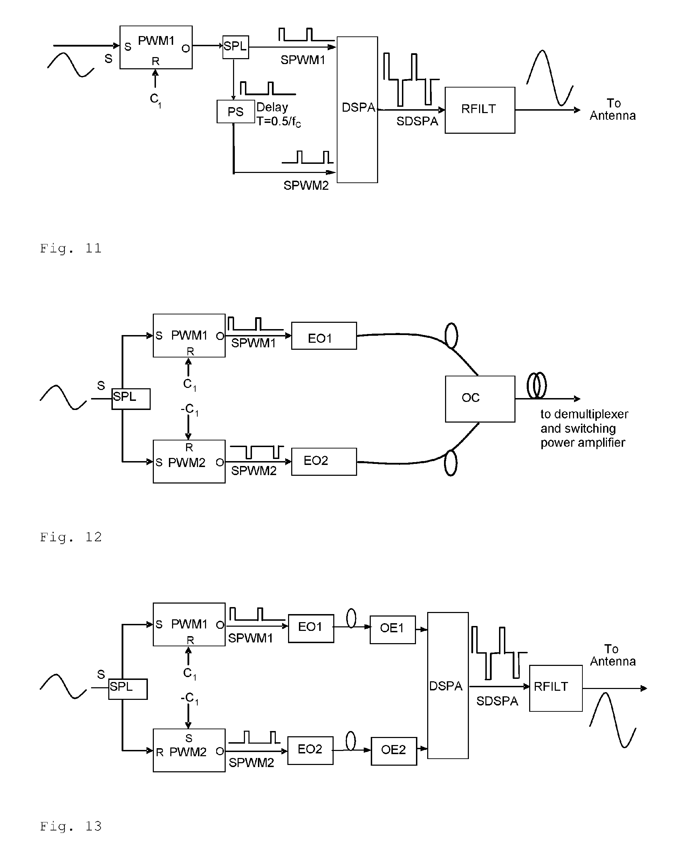

Fig. 11 schematically shows exemplarily a transmitter for amplification of distributed ternary pulse width modulated signals using a pulse width modulator, a splitter, a phase shifter and a differential switching power amplifier according to an embodiment of the invention.

In case the envelope a of the input signal S=a*sin (2πf_{c}t+ϕ) is only slowly varying compared to the term 2πf_{c}t, the inverted second pulse width modulated signal SPWM2 as depicted in fig. 8 and 9 and described above can be approximated as a phase shifted, i.e. delayed version of the first pulse width modulated signal SPWM1. If the bandwidth of the baseband signal is small compared to the carrier frequency f_{c}, this approximation is very exact. This allows a further simplified implementation of an embodiment of the invention as depicted in fig. 11.

The transmitter comprises a pulse width modulator PWM1, a splitter or coupler SPL, a phase shifter or delay PS, a differential switching power amplifier DSPA, and a reconstruction filter RFILT.

The input signal S=a*sin (2πf_{c}t+ϕ) is transmitted to a signal input of the pulse width modulator PWM1, and a first comparator threshold C₁ is fed to a reference input of the pulse width modulator PWM1. As depicted in the upper diagram in fig. 4 and described above, a first pulse width modulated signal SPWM1 results from a comparison of the input signal S with the first comparator threshold C₁.

Said first pulse width modulated signal SPWM1 is duplicated by means of the splitter or coupler SPL. As in the embodiment in fig. 11 only the functionality of a splitter is required, the usage of a splitter SPL is preferred.

Said first pulse width modulated signal SPWM1 is sent to a first input of the differential switching power amplifier DSPA.

Said first pulse width modulated signal SPWM1 is also transmitted to an input of the phase shifter PS. The phase shifter PS delays the first pulse width modulated signal SPWM1 by a half period of the sine wave at carrier frequency f_{c}, i.e. by T= 1/2/f_{c}, resulting in a delayed second pulse width modulated signal SPWM2, which corresponds to the inverted second pulse width modulated signal SPWM2 as depicted in fig. 8 and 9 and described above.

The delayed second pulse width modulated signal SPWM2 is sent to a second input of the differential switching power amplifier DSPA.

As depicted in fig. 8 and 9 and described above, for amplification of the two binary pulse width modulated signals, the differential switching power amplifier DSPA is used. The two inputs of the differential switching amplifier DSPA are fed with the first pulse width modulated signal SPWM1, and with the delayed second pulse width modulated signal SPWM2. Due to the differential operation, the differential switching power amplifier DSPA amplifies separately the two inputs and inherently adds them.

Instead of employing a differential power amplifier, a H-Bridge according to figure 10 can be employed by connecting SPA1 with signal SPWM1, SPA3 with the inversion of signal SPWM1 denoted as *̅S̅P̅W̅M̅*̅1̅ and connecting SPA2 with signal SPWM2, and connecting SPA3 with the inversion of signal SPWM2 denoted as *S̅P̅W̅M̅2̅*

The amplification of the first pulse width modulated signal SPWM1, and the delayed second pulse width modulated signal SPWM2 results in a ternary signal SDSPA. Said ternary signal SDSPA corresponds to an amplified copy of a ternary pulse width modulated signal as e.g. depicted in fig. 5.

The ternary signal SDSPA is then filtered in a reconstruction filter RFILT preferably of low pass or band pass type for converting the ternary signal SDSPA into an analogue signal.

In an alternative of the embodiment, instead of the phase shifter PS, an additional printed circuit board track can be used to delay the first pulse width modulated signal SPWM1 by a half period of the sine wave at carrier frequency f_{c}.

A transmitter according to one of the embodiments of the invention as described above can be used as a transmitter for amplification and transmission of signals over an air interface. In such a scenario, a modulation of signals in pulse width modulators can be performed in a base station, whereas an amplification of modulated signals can be performed remotely e.g. in remote radio heads. As it is advantageous with respect to error rate and energy efficiency to transmit modulated signals optically, in the following several embodiments according to the invention with optical transmission of modulated signals are described.

Fig. 12 schematically shows exemplarily a transmitter for amplification of distributed ternary pulse width modulated signals using two pulse width modulators, two electro-optical converters and an optical combiner for optical transmission of pulse width modulated signals to switching power amplifiers according to an embodiment of the invention.

The transmitter comprises a splitter or coupler SPL, a first and a second pulse width modulator PWM1, PWM2, a first and a second electro-optical converter EO1, E02, and an optical combiner OC.

An input signal S=a*sin(2nf_{c}t+(p) is duplicated by means of the splitter or coupler SPL. As in the embodiment in fig. 12 only the functionality of a splitter is required, the usage of a splitter SPL is preferred.

The input signal S is transmitted to a signal input of the first pulse width modulator PWM1, and a first comparator threshold c₁ is fed to a reference input of the first pulse width modulator PWM1. As depicted in the upper diagram in fig. 4 and described above, a first pulse width modulated signal SPWM1 results from a comparison of the input signal S with the first comparator threshold C₁, and said first pulse width modulated signal SPWM1 is sent to an input of the first electro-optical converter EO1.

In the first electro-optical converter EO1, said first pulse width modulated signal SPWM1, which is a binary pulse width modulated signal, is converted from an electrical signal to an optical signal, and transmitted via an optical connection to a first input of the optical combiner OC.

The input signal S is also transmitted to a signal input of the second pulse width modulator PWM2, and a second comparator threshold -c₁ is fed to a reference input of the second pulse width modulator PWM2. As depicted in the lower diagram in fig. 4 and described above, a second pulse width modulated signal SPWM2 results from a comparison of the input signal S with the second comparator threshold -c₁, and said second pulse width modulated signal SPWM2 is sent to an input of the second electro-optical converter E02.

In the second electro-optical converter E02, said second pulse width modulated signal SPWM2, which is a binary pulse width modulated signal, is converted from an electrical signal to an optical signal, and transmitted via an optical connection to a second input of the optical combiner OC.

The electro-optical converters EO1, E02 can either work on the same optical frequency or on different optical frequencies.

From the optical combiner, the first and second optical pulse width modulated signals SPWM1, SPWM2 are transmitted via an optical connection to a demultiplexer and then to switching power amplifiers SPA1 and SPA2 as depicted in fig. 7. The further signal processing is as depicted in fig. 7 and described above. In fig. 12, the demultiplexer and the switching power amplifiers are not depicted for the sake of simplicity.

Fig. 13 schematically shows exemplarily a transmitter for amplification of distributed ternary pulse width modulated signals according to fig. 9, with additionally two electro-optical converters E01, E02 and two opto-electrical converters OE1, OE2 for optical transmission of pulse width modulated signals to the differential switching power amplifier according to an embodiment of the invention.

As the embodiment in fig. 13 in principle corresponds to the embodiment depicted in fig. 9, only the differences are described in the following.

The first pulse width modulated signal SPWM1, which is a binary pulse width modulated signal, is transmitted from the first pulse width modulator PWM1 to the first electro-optical converter E01, and is converted from an electrical signal to an optical signal in the first electro-optical converter E01. The first optical pulse width modulated signal SPWM1 is then transmitted via an optical connection to the first opto-electrical converter OE1, and is converted from an optical signal to an electrical signal in the first opto-electrical converter OE1. The first opto-electrical converter OE1 is in turn connected to a first input of the differential switching power amplifier DSPA.

The second pulse width modulated signal SPWM2, which is a binary pulse width modulated signal, is transmitted from the second pulse width modulator PWM2 to the second electro-optical converter E02, and is converted from an electrical signal to an optical signal in the second electro-optical converter E02. The second optical pulse width modulated signal SPWM2 is then transmitted via an optical connection to the second opto-electrical converter OE2, and is converted from an optical signal to an electrical signal in the second opto-electrical converter OE2. The second opto-electrical converter OE2 is in turn connected to a second input of the differential switching power amplifier DSPA.

The electro-optical converters EO1, E02 can either work on the same optical frequency or on different optical frequencies.

The further processing of the signals is as described above in fig. 9.

Fig. 14 schematically shows exemplarily a transmitter for amplification of distributed ternary pulse width modulated signals according to fig. 11, with additionally an electro-optical converter E01 and an opto-electrical converter OE1 for optical transmission of pulse width modulated signals to the differential switching power amplifier according to an embodiment of the invention.

As the embodiment in fig. 14 in principle corresponds to the embodiment depicted in fig. 11, only the differences are described in the following.

The first pulse width modulated signal, which is a binary pulse width modulated signal, is transmitted from the pulse width modulator PWM1 to the electro-optical converter EO1, and is converted from an electrical signal to an optical signal in the electro-optical converter EO1. The first optical pulse width modulated signal SPWM1 is then transmitted via an optical connection to the opto-electrical converter OE1, and is converted from an optical signal to an electrical signal in the opto-electrical converter OE1. The opto-electrical converter OE1 is in turn connected to an input of the splitter or converter SPL.

The further processing of the signals is as described above in fig. 11.

Fig. 15 schematically shows exemplarily a transmitter for amplification of distributed ternary pulse width modulated signals according to fig. 13, with additionally an optical multiplexer MUX and an optical demultiplexer DEMUX for combined optical transmission of pulse width modulated signals to the differential switching power amplifier DSPA according to an embodiment of the invention.

As the embodiment in fig. 15 in principle corresponds to the embodiment depicted in fig. 13, only the differences are described in the following.

From the first electro-optical converter EO1, the first optical pulse width modulated signal SPWM1 is transmitted via an optical connection to a first input of the multiplexer MUX, and from the second electro-optical converter E02, the second optical pulse width modulated signal SPWM2 is transmitted via an optical connection to a second input of the multiplexer MUX.

The first and the second optical pulse width modulated signals SPWM1, SPWM2 are multiplexed and transmitted via a common optical connection from the multiplexer to the demultiplexer DEMUX.

In the demultiplexer DEMUX, the first and the second optical pulse width modulated signals SPWM1, SPWM2 are demultiplexed and transmitted via optical connections to an input of the first opto-electrical converter OE1, and to an input of the second opto-electrical converter OE2 respectively.

The optical multiplexer MUX and demultiplexer DEMUX can be implemented e.g. as polarisation mode multiplexer and demultiplexer, as optical fibre combiner and splitter respectively or as a wavelength multiplexer and demultiplexer respectively.

The electro-optical multiplexer EO1 and E02 work on different optical frequencies if wavelength multiplexing is used as multiplexing method.

The further processing of the signals is as described above in fig. 13.

In the embodiments described above, the electro-optical converters EO1, E02 as described above can be implemented e.g. as a directly modulated laser or as a laser with external optical modulator, as e.g. a Mach-Zehnder modulator or an electro absorption modulator. Instead of a laser, also light emitting diodes (LED) can be used.

The opto-electrical converters OE1, OE2 as described in the embodiments above can be implemented e.g. as a photo diode.

In fig. 16, the principle concept of a differential switching power amplifier system according to the state-of-the-art based on voltage switching is shown exemplarily, which can in principle be used in the respective embodiments described above in figs. 8, 9 and 11. Said differential switching power amplifier system comprises a first and a second pulse width modulator PWM1, PWM2 with inputs for reception of a digital or analogue radio frequency input signal S. An output of the first and the second pulse width modulator PWM1 and PWM2 respectively is connected to an input of a first and a second driver DR1 and DR2 respectively.

An output of the driver DR1 is connected to a gate of a first transistor T1, and an output of the driver DR2 is connected to a gate of a second transistor T2.

A source of the first transistor T1 is connected to a drain of the second transistor T2, and a source of the second transistor T2 is connected to ground.

The source of the first transistor T1 and the drain of the second transistor T2 are connected to an RF output via a reconstruction filter RFILT that comprises an inductor L and a capacitor C in series. There are variants of the L-C filter topology which however are of no importance for the invention as disclosed.

A drain of the first transistor T1 is connected to a supply of a constant voltage source.

In a method for signal amplification using a differential voltage switching power amplifier system according to the state-of-the-art as shown in fig. 16, digital or analogue RF input signals S are sent to the pulse width modulators PWM1 and PWM2.

In the pulse width modulators PWM1 and PWM2, the digital or analogue RF input signals S are converted into a first and a second binary pulse width modulated signal SPWM1 and SPWM2 respectively as described above under fig. 4 by means of comparison of the input signals S with two different comparator thresholds, and in case of a digital RF input signal using a so-called sample-and-hold output. The first and second binary pulse width modulated signal SPWM1 and SPWM2 respectively with binary amplitude levels is provided at the output of the pulse width modulator PWM1 and PWM2 respectively.

Said first and second binary pulse width modulated signals SPWM1 and SPWM2 are sent to the driver DR1 and DR2 respectively. The driver DR1 generates first driver signals based on the first binary pulse width modulated signal SPWM1, and the driver DR2 generates second driver signals based on inverting the second binary pulse width modulated signal SPWM2.

In an alternative, instead of inverting the second binary pulse width modulated signal SPWM2, the reference signal input, and the desired signal input of the second pulse width modulator PWM2 are exchanged as described under fig. 9.

In a further alternative, instead of inverting the second binary pulse width modulated signal SPWM2, only a first binary pulse width modulated signal SPWM1 is generated in a first pulse width modulator PWM1 and duplicated using a splitter or a coupler, and one of said duplicated signals is phase shifted as described above under fig. 11 leading to the inverted second binary pulse width modulated signal SPWM2.

The first driver signals are sent to the gate of the first transistor T1, and the second driver signals are sent to the gate of the second transistor T2. If the output signal of the first driver DR1 is low, and the output signal of the second driver DR2 is high, then the voltage at the drain of the second transistor T2, and at the source of the first transistor T1 respectively is low, i.e. V_{Lamp}. If the output signal of the first driver DR1 is high, and the output signal of the second driver DR2 is low, then the voltage at the drain of the second transistor T2, and at the source of the first transistor T1 respectively is high, i.e. V_{Hamp}. If the output signal of both the first driver DR1 and the second driver DR2 is low, then the voltage at the drain of the second transistor T2, and at the source of the first transistor T1 respectively shall be (V_{Hamp}+V_{Lamp)} /2.

The described amplifier architecture with two transistors T1, T2 is just an example, and in alternative architectures, more than two transistors are used, which has however no influence on the invention. Such alternative architectures are e.g. multibit architectures, using two transistors more per each bit more.

The gate driving signal for transistor T1 is referenced to the source of T1. As the source of T1 is connected to the RF output, this source potential is floating. For transistor T2 the source potential is connected to ground, i.e. it is static.

The capacitor C and the inductor L together build exemplarily a reconstruction filter RFILT used to generate from amplified ternary pulse width modulated signals smooth analogue output signals that are provided at the RF output.

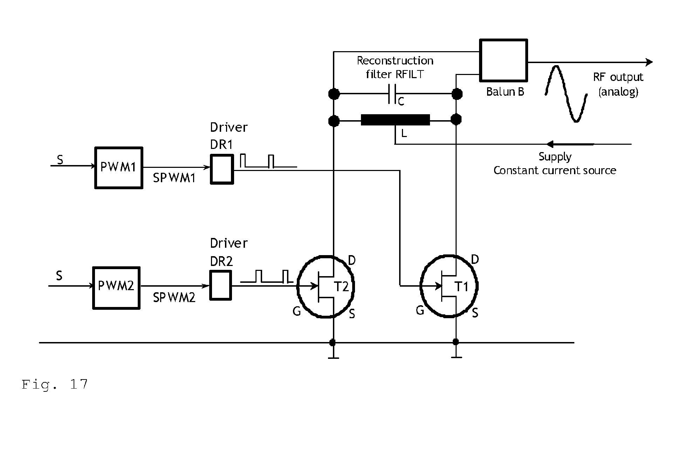

In fig. 17, a differential switching power amplifier system according to the state-of-the-art based on current switching is shown, which can in principle be used in the respective embodiments described above in figs. 8, 9 and 10. Said differential switching power amplifier system comprises a first and a second pulse width modulator PWM1, PWM2 with inputs for reception of a digital or analogue radio frequency input signal S. An output of the first and the second pulse width modulator PWM1 and PWM2 respectively is connected to an input of a first and a second driver DR1 and DR2 respectively.

An output of the driver DR1 is connected to the gate of a first transistor T1, and an output of the driver DR2 is connected to the gate of a second transistor T2.

Both a source of the first transistor T1 and a source of the second transistor T2 are connected to ground.

A drain of the first transistor T1 is connected to a first input of an inductor L and to a first input of a capacitor C, and a drain of the second transistor T2 is connected to a second input of the inductor L and to a second input of the capacitor C. The capacitor C and the inductor L build together a reconstruction filter RFILT. There are variants of the L-C filter topology which however are of no importance for the invention as disclosed.

A supply of a constant current source is connected to a third input of the inductor L.

Furthermore, the drain of the first transistor T1 is connected to a first input of a balun B, and the drain of the second transistor T2 is connected to a second input of the balun B. The balun B transforms a balanced input signal to a single ended signal. At the balun's output an analogue RF output signal is provided.

Preferably, the drivers DR1, DR2 and the transistors T1 and T2 are fabricated in Gallium Nitride (GaN) technology.

In a method for signal amplification using a differential current switching power amplifier system according to the state-of-the-art as shown in fig. 17, digital or analogue RF input signals S are sent to the pulse width modulators PWM1 and PWM2.

In the pulse width modulators PWM1 and PWM2, the digital or analogue RF input signals S are converted into a first and a second binary pulse width modulated signal SPWM1 and SPWM2 respectively as described above under fig. 4 by means of comparison of the input signals S with two different comparator thresholds, and in case of S being a digital signal using a so-called sample-and-hold output. The first and second binary pulse width modulated signal SPWM1 and SPWM2 respectively is provided at the output of the pulse width modulator PWM1 and PWM2 respectively.

Said first and a second binary pulse width modulated signals SPWM1 and SPWM2 are sent to the driver DR1 and DR2 respectively. The driver DR1 generates first driver signals based on the first binary pulse width modulated signal SPWM1, and the driver DR2 generates second driver signals based on inverting the second binary pulse width modulated signal SPWM2.

In an alternative, instead of inverting the second binary pulse width modulated signal SPWM2, the reference signal input, and the desired signal input of the second pulse width modulator PWM2 are exchanged as described under fig. 9.

In a further alternative, instead of inverting the second binary pulse width modulated signal SPWM2, only a first binary pulse width modulated signal SPWM1 is generated in a first pulse width modulator PWM1 and duplicated using a splitter or a coupler, and one of said duplicated signals is phase shifted as described above under fig. 11 leading to the inverted second binary pulse width modulated signal SPWM2.

The first driver signals are sent to the gate of the first transistor T1, and the second driver signals are sent to the gate of the second transistor T2. The signal generation by means of the first and second transistor T1 and T2 is similar as described above under fig. 16. The described amplifier architecture with two transistors T1, T2 is just an example, and in alternative architectures, more than two transistors are used, which has however no influence on the invention. Such alternative architectures are e.g. multibit architectures, using two transistors more per each bit more.

In the first transistor T1and in the second transistor T2, the first driver signals and the second driver signals respectively are amplified resulting in first and a second amplifier signals.

The capacitor C and the inductor L build together an exemplary reconstruction filter RFILT used to generate smooth analogue signals out of the first and the second amplifier signals.

The smoothed first and second analogue signals are sent to the balun B, in which the smoothed first and second analogue signals are added together, thus removing common or identical distortions of the input signals of the balun B. In other words, the balun B converts balanced signals to unbalanced signals. The unbalanced RF output signals are provided at the output of the balun B.

In the embodiments described above, out of an input signal, a distributed ternary pulse width modulated signal is generated which is composed out of two binary pulse width modulated signals. However, generally an input signal can also be converted into an arbitrary distributed multi-level signal which is composed out of multiple binary pulse width modulated signals by means of using multiple pulse width modulators with different comparator thresholds, amplifying the multiple binary pulse width modulated signals, and adding the amplified multiple binary pulse width modulated signals.

As an example for an application of a transmitter according to the invention, a base station in a wireless communication network can comprise a transistor according to one of the embodiments described above, and an antenna network for transmission of signals over an air interface.

## Claims

1. A method for signal amplification of an input signal (S) using at least one pulse width modulator (PWM1, PWM2) and at least one switching power amplifier (SPA1, SPA2, DSPA), wherein
● the input signal (S) is modulated in said at least one pulse width modulator (PWM1, PWM2) resulting in at least two pulse width modulated signals with two levels (SPWM1, SPWM2),
● said at least two pulse width modulated signals with two levels (SPWM1, SPWM2) are amplified in said at least one switching power amplifier (SPA1, SPA2, DSPA) resulting in a multi-level signal with at least three levels (SSPA, SDSPA),
● and said multi-level signal with at least three levels (SSPA, SDSPA) is converted to an analogue signal.

2. A method according to claim 1, wherein
● the input signal (S) is compared to a first threshold (C₁) in a first pulse width modulator of said at least one pulse width modulator (PWM1, PWM2),
● a first pulse width modulated signal (SPWM1) of said at least two pulse width modulated signals (SPWM1, SPWM2) is generated by means of pulses (P1) that are generated when a difference between said input signal (S) and said first threshold (C₁) has a first predefined algebraic sign,
● the input signal (S) is compared to a second threshold (-c₁) in a second pulse width modulator of said at least one pulse width modulator (PWM1, PWM2),
● and a second pulse width modulated signal (SPWM2) of said at least two pulse width modulated signals (SPWM1, SPWM2) is generated by means of pulses (P2) that are generated when a difference between said input signal (S) and said second threshold (-c₁) has a second predefined algebraic sign.

3. A method according to claim 2, wherein
● the first pulse width modulated signal (SPWM1) is amplified in a first switching power amplifier (SPA1) of said at least one switching power amplifier (SPA1, SPA2) resulting in a first amplified modulated signal (SSPA1),
● the second pulse width modulated signal (SPWM2) is amplified in a second switching power amplifier (SPA2) of said at least one switching power amplifier (SPA1, SPA2) resulting in a second amplified modulated signal (SSPA2),
● and the first amplified modulated signal (SSPA1) and the second amplified modulated signal (SSPA2) are combined resulting in said multi-level signal with three levels (SSPA).

4. A method according to claim 2, wherein the first pulse width modulated signal (SPWM1) and the second pulse width modulated signal (SPWM2) are amplified in a differential switching power amplifier (DSPA).

5. A method according to claim 4, wherein one of said first pulse width modulated signal (SPWM1) and said second pulse width modulated signal (SPWM2) is inverted before amplification in said differential switching power amplifier (DSPA).

6. A method according to claim 4, wherein in one of said first pulse width modulator (PWM1) and said second pulse width modulator (PWM2), the input signal (S) is fed to an input for a reference signal, and a reference signal indicating a threshold (c₁, -c₁) is fed to an input for a data signal.

7. A method according to claim 1, wherein
● the input signal (S) is compared to a threshold (C₁) in a pulse width modulator (PWM1),
● a pulse width modulated signal with two levels (SPWM1) is generated by means of pulses (P1) that are generated when a difference between said input signal (S) and said threshold (C₁) has a predefined algebraic sign,
● said pulse width modulated signal with two levels (SPWM1) is duplicated resulting in a first and a second pulse width modulated signal with two levels,
● the second pulse width modulated signal is delayed resulting in a delayed pulse width modulated signal (SPWM2),
● and the first pulse width modulated signal (SPWM1) and the delayed pulse width modulated signal (SPWM2) are amplified in a differential switching power amplifier (DSPA).

8. A method according to claim 1, wherein
● the input signal (S) is compared to a first threshold (C₁) in a first pulse width modulator (PWM1) of said at least one pulse width modulator (PWM1, PWM2),
● a first pulse width modulated signal (SPWM1) of said at least two pulse width modulated signals (SPWM1, SPWM2), and an inverted first pulse width modulated signal (*̅S̅P̅W̅M̅*̅1̅) are generated by means of pulses (P1) that are generated when a difference between said input signal (S) and said first threshold (c₁) has a predefined algebraic sign,
● the input signal (S) is compared to a second threshold (-c₁) in a second pulse width modulator (PWM2) of said at least one pulse width modulator (PWM1, PWM2),
● a second pulse width modulated signal (SPWM2) of said at least two pulse width modulated signals (SPWM1, SPWM2), and an inverted second pulse width modulated signal (*̅S̅P̅R̅V̅*̅2̅) are generated by means of pulses (P2) that are generated when a difference between said input signal (S) and said second threshold (-c₁) has a predefined algebraic sign,
● and the first pulse width modulated signal (SPWM1), the inverted first pulse width modulated signal (*̅S̅P̅W̅M̅*̅1̅), the second pulse width modulated signal (*̅S̅P̅W̅M̅*̅2̅), and the inverted second pulse width modulated signal (*̅S̅P̅W̅M̅*̅2̅) are amplified using a H-bridge power amplifier.

9. A method according to any of the preceding claims,
wherein at least one pulse width modulated signal (SPWM1, SPWM2) is converted from an electrical signal to an optical signal in at least one electro-optical converter (EO1, EO2), transmitted over at least one optical connection, and converted from an optical signal to an electrical signal in at least one opto-electrical converter (OE1, OE2).

10. A transmitter comprising at least one pulse width modulator (PWM1, PWM2), at least one switching power amplifier (SPA1, SPA2, DSPA) for signal amplification of an input signal (S), and a converting device for digital-to-analogue conversion (RFILT), wherein
● said at least one pulse width modulator (PWM1, PWM2) is adapted to modulate the input signal (S) in said at least one pulse width modulator (PWM1, PWM2) resulting in at least two pulse width modulated signals with two levels (SPWM1, SPWM2),
● said at least one switching power amplifier (SPA1, SPA2, DSPA) is adapted to amplify said at least two pulse width modulated signals with two levels (SPWM1, SPWM2) resulting in a multi-level signal with at least three levels (SSPA, SDSPA),
● and said converting device for digital-to-analogue conversion (RFILT) is adapted to convert said multi-level signal with at least three levels (SSPA, SDSPA) to an analogue signal.

11. A base station comprising a transmitter according to claim 10 and at least one antenna network for transmission of signals over an air interface.
